# FASCICULE DE BREVET EUROPEEN

(11) **EP 1 953 775 B1**
(45) Date de publication et mention de la délivrance du brevet: **10.03.2010**
(21) Numéro de dépôt: 08100947.4
(22) Date de dépôt: 25.01.2008
(51) Int. Cl.: H01F 17/00

(54) **Inductance multiniveaux**
Induktivität auf mehreren Stufen
Multi-level inductance

(30) Priorité: 30.01.2007 FR 0752957
(43) Date de publication de la demande: 06.08.2008
(73) Titulaire: STMICROELECTRONICS SA, 92120 Montrouge (FR)
(72) Inventeur: Noire, Aline, 37360 Saint Antoine du Rocher (FR); Therond, Benjamin, 37000 Tours (FR)
(74) Mandataire: de Beaumont, Michel

(56) Documents cités:
- EP-A- 1 244 210
- EP-A- 1 283 663
- EP-A- 1 363 296
- FR-A1- 2 862 158
- US-A1- 2002 157 849
- US-A1- 2003 071 706
- US-A1- 2004 140 878
- ATTA R M H: "Multi-layer double coil micro-fabricated transformer" SENSORS AND ACTUATORS A, ELSEVIER SEQUOIA S.A., LAUSANNE, CH, vol. 112, no. 1, 15 avril 2004 (2004-04-15), pages 61-65, XP004504726 ISSN: 0924-4247
- SKRASTINS ET AL: "SYNTHESIS AND PHARM" KHIMIKO-FARMATSEVTICHESKII ZHURNAL, MOSCOW, RU, vol. 23, no. 11, 1989, pages 1323-1326, XP001055133 ISSN: 0023-1134

## Description

### Domaine de l'invention

La présente invention concerne de façon générale la réalisation d'éléments inductifs pour des circuits électroniques. L'invention s'applique plus particulièrement à la réalisation d'une inductance dans plusieurs niveaux conducteurs superposés.

### Exposé de l'art antérieur

Que ce soit dans le domaine des circuits intégrés où pour la réalisation de composants passifs utilisant des technologies similaires, on cherche généralement à minimiser l'encombrement d'un élément inductif en superposant différents enroulements conducteurs formés dans des niveaux successifs. Une telle superposition permet, entre autres, de bénéficier de l'effet de la mutuelle inductance entre les enroulements pour accroître la valeur de l'inductance pour un même encombrement en surface.

Un problème qui se pose est de réduire le nombre de vias nécessaires pour raccorder électriquement les différents enroulements des différents niveaux sans pour autant requérir un niveau supplémentaire rien que pour effectuer ces connexions.

Une autre difficulté est de préserver la superposition des spires pour conserver l'effet de la mutuelle inductance.

Le document EP-A-1 363 296 décrit un filtre dont un élément inductif est formé d'enroulements plans dans différents niveaux conducteurs.

### Résumé de l'invention

La présente invention vise à pallier tout ou partie des inconvénients des inductances multiniveaux classiques. L'invention vise plus particulièrement la réalisation d'une inductance multiniveaux dans au moins trois niveaux conducteurs.

Un objet vise une solution minimisant le nombre de vias nécessaires dans la réalisation de l'inductance pour un nombre donné de niveaux conducteurs.

Un autre objet vise à préserver la superposition des enroulements réalisés dans les différents niveaux.

Un autre objet vise une solution compatible avec un nombre pair ou impair d'enroulements.

Un autre objet vise une solution compatible avec les technologies de fabrication des circuits intégrés ainsi que des circuits passifs.

Pour atteindre tout ou partie de ces objets ainsi que d'autres, il est prévu un élément inductif formé d'enroulements plans dans différents niveaux conducteurs, dans lequel les enroulements sont réalisés dans un nombre de niveaux inférieurs d'une unité par rapport au nombre d'enroulements, les enroulements étant reliés les uns aux autres au moyen d'un nombre de vias égal au nombre de niveaux conducteurs et deux des enroulements étant interdigités dans un même niveau.

Selon un mode de réalisation, les bornes d'accès à l'élément inductif sont à l'extérieur de deux enroulements formés dans deux niveaux différents.

Selon un mode de réalisation, les enroulements sont de forme générale rectangulaire, circulaire ou octogonale.

Selon un mode de réalisation, les enroulements ont la même largeur de piste.

Selon un mode de réalisation, les enroulements ont des largeurs de piste et/ou des espacements entre les tours différents d'un niveau à l'autre.

Selon un mode de réalisation, les enroulements sont formés dans des niveaux de métallisation d'une technologie d'intégration de circuits passifs.

Selon un mode de réalisation, les enroulements sont formés dans des niveaux de métallisation d'un circuit intégré.

Il est également prévu un filtre passif.

Il est également prévu un circuit de protection contre des décharges électrostatiques.

Il est également prévu un circuit d'alimentation.

Il est également prévu un dispositif d'émission-réception radiofréquence.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente de façon schématique un système auquel s'applique à titre d'exemple la présente invention ;
la figure 2 est une vue en coupe schématique d'un circuit électronique du type auquel s'applique à titre d'exemple la présente invention ;
les figures 3A, 3B et 3C sont des vues de dessus d'un mode de réalisation d'une inductance multiniveaux ;
les figures 4A, 4B et 4C sont des coupes prises respectivement selon les lignes I-I des figures 3A à 3C ;
les figures 5A, 5B et 5C sont des vues en coupe prises respectivement selon les lignes II-II des figures 3A à 3C ;
la figure 6 est une vue de dessus illustrant une variante d'une inductance multiniveaux ; et
la figure 7 est une vue en coupe partielle illustrant une autre variante d'une inductance multiniveaux.

De mêmes éléments ont été désignés par les mêmes références aux différentes figures.

### Description détaillée

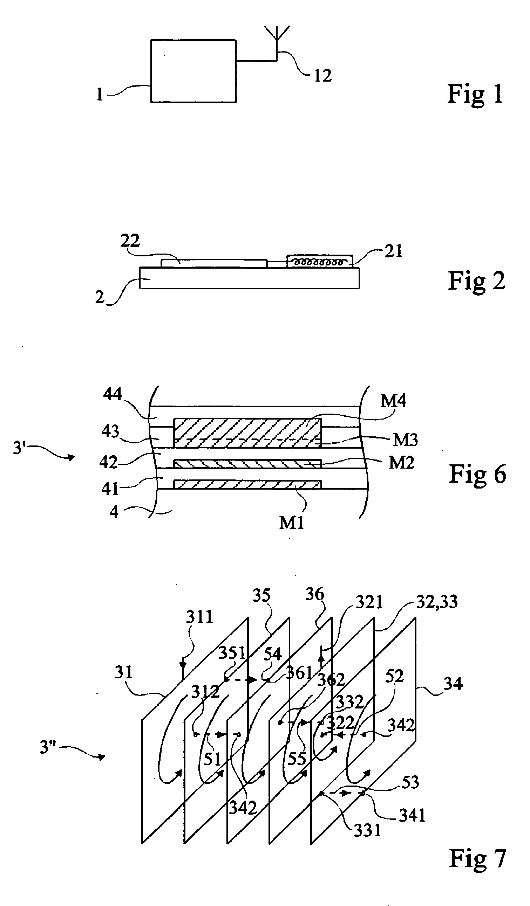

La figure 1 représente de façon très schématique un dispositif électronique du type auquel s'applique à titre d'exemple la présente invention. Il s'agit d'un dispositif 1 d'émission et/ou de réception radiofréquence pourvu d'une antenne 12. Cette antenne 12 est reliée au circuit 1 qui contient divers éléments d'émission-réception et d'interprétation des signaux émis et reçus. Le dispositif 1 peut contenir un ou plusieurs éléments inductifs multiniveaux, par exemple, pour former des transformateurs à changement de mode (balun) des combineurs/diviseurs de puissance, des éléments inductifs de filtrage, l'antenne 12, etc.

La figure 2 est une représentation en coupe schématique d'un circuit électronique 2 comportant un élément inductif 21 représenté symboliquement par une bobine, mais réalisé sous la forme d'une inductance multiniveaux. Cet élément 21 est relié à d'autres éléments 22 du circuit 2, qu'il s'agisse d'autres composants passifs ou de zones actives réalisées dans un substrat semiconducteur.

Une ou plusieurs inductances peuvent servir d'éléments inductifs dans des filtres passifs, dans des circuits d'alimentation par exemple des alimentations à découpage, dans des circuits de protection contre des décharges électrostatiques (ESD), etc.

L'invention sera décrite par la suite en relation avec la réalisation d'un enroulement inductif dans plusieurs niveaux métalliques successifs d'un empilement. Elle s'applique toutefois plus généralement quel que soit le type de niveau conducteur utilisé (métal, semiconducteur convenablement dopé, etc.), que les niveaux soient successifs ou non dans l'empilement réalisant le circuit électronique et quel que soit le nombre d'éléments inductifs réalisés.

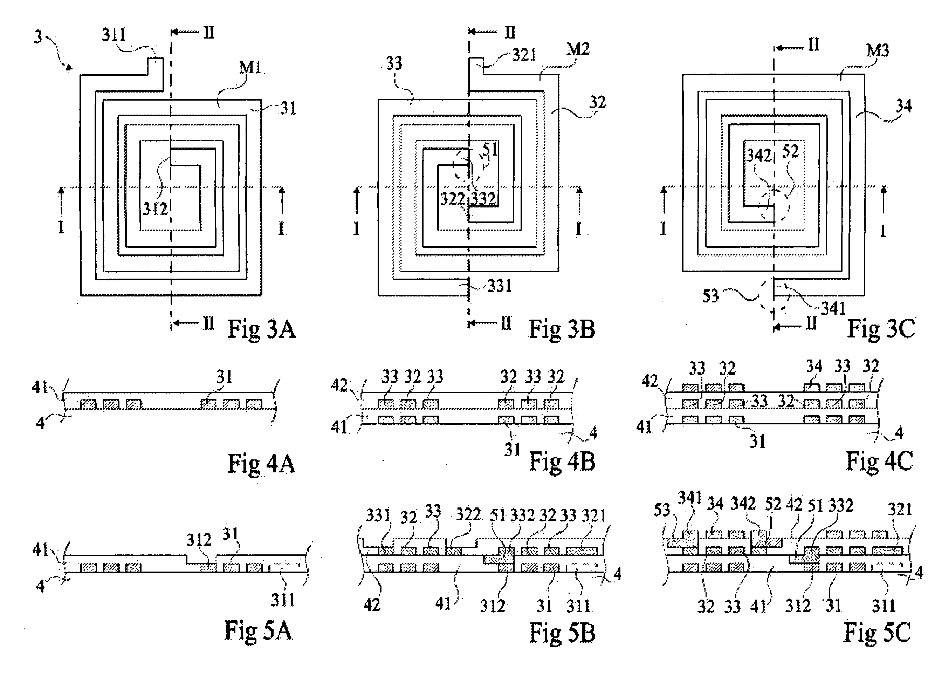

Les figures 3A, 3B et 3C sont des vues de dessus d'un élément inductif. Ces figures représentent des niveaux métalliques successifs déposés sur un substrat par exemple isolant (non visible aux figures 3A à 3C).

Les figures 4A, 4B et 4C sont des vues en coupe prises selon les lignes 1-1 des figures 3A à 3C.

Les figures 5A, 5B et 5C sont des coupes respectives prises selon les lignes II-II des figures 3A à 3C.

Dans cet exemple, un élément inductif 3 est réalisé dans trois niveaux de métal M1 (figure 3A), M2 (figure 3B) et M3 (figure 3C), sous la forme de quatre enroulements plans 31 (figure 3A), 32 et 33 (figure 3B) et 34 (figure 3C). Deux enroulements 32 et 33 sont réalisés dans le même niveau (dans cet exemple M2) en étant interdigités l'un avec l'autre. Chacun de ces deux enroulements 32 et 33 a approximativement moitié moins de tours que les autres enroulements.

En supposant que les niveaux M1, M2 et M3 constituent des niveaux successifs dans la réalisation du circuit, on part d'un substrat 4 (figures 4A et 4B), par exemple un substrat isolant. L'enroulement 31 est réalisé dans le premier niveau de métal M1, son extrémité externe 311 définissant une des deux bornes de l'élément inductif tandis que son extrémité interne 312 est destinée à être raccordée par un via 51 (figures 3B et 5B) à l'enroulement 33 du niveau M2. Dans ce niveau M2, un premier enroulement 32 part d'une extrémité externe 321 définissant l'autre borne de l'élément inductif pour se terminer à une extrémité interne 322 qui est destinée à être connectée par un via 52 au niveau M3 déposé ultérieurement (figures 3C, 4C et 5C). Le deuxième enroulement 33 du niveau M2 part d'une extrémité externe 331 (par exemple, diamétralement opposée à l'extrémité 321) pour se terminer à son extrémité interne 332 au niveau du via 51. L'extrémité 331 est destinée à être reliée par un troisième via 53 à une extrémité externe 341 de l'enroulement 34 du niveau M3.

Dans l'exemple représenté, les enroulements 31 et 34 tournent dans le sens inverse des aiguilles d'une montre depuis leurs extrémités externes respectives 311 et 341. Les enroulements 32 et 33 du niveau M2 tournent dans le sens des aiguilles d'une montre depuis leurs extrémités externes respectives 321 et 331. Il en découle que le courant peut circuler toujours dans le même sens quel que soit le niveau. Partant de l'extrémité 311 dans le niveau M1, le courant circule de l'extérieur vers l'intérieur jusqu'à l'extrémité 312, passe au niveau M2 par le via 51, puis de l'intérieur (extrémité 332) vers l'extérieur de l'enroulement 33 jusqu'à son extrémité 331, passe par le via 53 dans l'enroulement 34 (niveau M3) où il circule de l'extérieur (extrémité 341) vers l'intérieur jusqu'à l'extrémité 342 pour revenir dans le niveau M2 par le via 52 et terminer la circulation de l'intérieur (extrémité 322) vers l'extérieur, jusqu'à l'extrémité 321. L'inverse est bien entendu possible.

On voit que trois vias suffisent pour réaliser l'élément inductif dans trois niveaux conducteurs. Un avantage de diminuer le nombre de vias est, pour des réalisations en circuit intégré, de diminuer les résistances dues à ces vias et pour des réalisations en circuit passif (pistes plus épaisses), de diminuer l'encombrement en surface.

Aux figures 4A à 4C et 5A à 5C, ont été illustrés des niveaux isolants 41 et 42 intercalés entre les niveaux M1 et M2. En pratique, un niveau isolant peut également être rapporté sur le niveau M3 avant de terminer le circuit. Au figures 5A et 5B, des ouvertures dans les niveaux 41 et 42 ont été illustrées aux emplacements des vias (respectivement 51, puis 52 et 53) réalisés dans le niveau ultérieur.

Un avantage de la structure proposée est que les vias sont situés à des extrémités des enroulements tels qu'ils peuvent, si besoin, être d'un diamètre supérieur à la largeur des pistes constitutives de ces enroulements. C'est ce qui a été illustré dans la représentation qui précède.

Un autre avantage est que l'encombrement de la structure est réduit par rapport à des structures classiques.

Un autre avantage est que l'ordre des niveaux conducteurs n'a pas d'importance, les vias de connexions des différentes extrémités ne traversant pas des pistes des enroulements. Il est ainsi possible d'adapter les niveaux empilés en fonction des niveaux dans lesquels se situent les pistes de reprise de contact pour les entrées/sorties 311 et 321 de l'élément inductif. On peut alors encore économiser des vias.

Un autre avantage est de permettre des largeurs de piste et/ou espacements entre les tours des enroulements différents d'un niveau à un autre en fonction des contraintes et possibilités de la technologie utilisée. Par exemple, ces dimensions sont adaptées en fonction des caractéristiques des niveaux de métallisation utilisées qui peuvent être différentes d'un niveau à l'autre. Si les niveaux utilisés le permettent, on peut cependant prévoir des largeurs et espacements identiques d'un niveau à l'autre, ce qui améliore le couplage.

La figure 6 représente, de façon très schématique et en coupe, une variante d'un élément inductif 3'. Quatre niveaux de métallisation M1 à M4 empilés sur un substrat 4 semiconducteur ou isolant et séparés les uns des autres par des couches isolantes 41 à 43 servent à réaliser l'inductance, un dernier niveau isolant 44 protégeant le dessus du circuit. Les niveaux M3 et M4 sont ici combinés pour former l'un des enroulements 31 ou 34, ou les deux enroulements 32 et 33. Cet exemple illustre le cas de l'utilisation de plusieurs niveaux pour un ou plusieurs des enroulements, par exemple pour des questions de résistance.

La figure 7 est une vue schématique illustrant une autre variante d'un élément inductif 3". Bien qu'elle ait été représentée avec un axe horizontal, la structure peut être à axe vertical. Par exemple, cinq niveaux sont utilisés pour réaliser l'élément inductif au moyen de six enroulements, dont deux enroulements 32 et 33 dans un même niveau. En regardant de la gauche dans la disposition de la figure, le premier enroulement 31 tourne de l'extérieur vers l'intérieur dans le sens des aiguilles d'une montre. Un premier via 51 relie son extrémité interne 312 à l'extrémité interne 352 d'un (cinquième) enroulement 35 réalisé dans le niveau adjacent. Cet enroulement tourne également dans le sens des aiguilles d'une montre jusqu'à son extrémité externe 351. Cette extrémité 351 est reliée par un (quatrième) via 54 à une extrémité externe 361 d'un (sixième) enroulement 36 réalisé dans le niveau adjacent à celui de l'enroulement 35. L'enroulement 36 tourne dans le sens des aiguilles d'une montre de l'extérieur vers l'intérieur. Son extrémité interne 362 est reliée par un (cinquième) via 55 à l'extrémité interne 332 du troisième enroulement 33. Celui-ci tourne dans le sens des aiguilles d'une montre de l'intérieur vers l'extérieur. Son extrémité externe 331 est reliée par le via 53 à l'extrémité externe 341 du quatrième enroulement 34 qui tourne dans les sens des aiguilles d'une montre de l'extérieur vers l'intérieur. L'extrémité interne 342 de l'enroulement 34 revient dans le niveau précédent par le via 52 pour connecter l'extrémité interne 322 du deuxième enroulement 32 qui tourne dans le sens des aiguilles d'une montre de l'intérieur vers l'extérieur et dont l'extrémité externe 321 définit la deuxième borne de l'élément inductif.

La structure est donc compatible avec un accroissement du nombre de niveaux conducteurs. Elle permet de réaliser un élément inductif sur N étages avec N niveaux conducteurs, en réalisant N+1 enroulements avec un nombre N de vias et en obtenant les extrémités de l'élément inductif à l'extérieur de la structure. Là encore, l'ordre des niveaux n'a pas d'importance pourvu que les vias supplémentaires par rapport aux trois vias de la structure minimale puissent être réalisés. On peut, par exemple, décaler (angulairement ou radialement) une ou les deux extrémités d'un enroulement pour qu'elles ne soient pas contactées par un via reliant des extrémités d'enroulements formés dans des niveaux qui l'encadrent. La structure proposée trouve un intérêt particulier dans le cas où le nombre de niveaux conducteurs disponibles est impair.

Pour une réalisation horizontale (axe horizontal) de l'élément inductif, il suffit de considérer que chaque tour d'un enroulement est réalisé dans deux niveaux conducteurs distincts au moyen de deux vias entre ces deux niveaux alors que les vias 51 à 55 sont en fait des tronçons conducteurs dans un même niveau. Le nombre de niveaux conducteurs requis correspond alors au double du nombre de tours des enroulements 31 et 34.

Bien entendu, la présente invention est susceptible de diverses variantes et modifications qui apparaîtront à l'homme de l'art. En particulier, bien que l'invention ait été décrite en relation avec une forme approximativement carrée des enroulements, elle est compatible avec tout autre forme (par exemple, circulaire, ovale, triangulaire, polygonale, etc.), sachant qu'une structure carrée ou rectangulaire est généralement préférée car elle optimise la superposition des enroulements dans les différents niveaux, ce qui accroît la mutuelle inductance, donc la valeur inductive obtenue pour un encombrement donné.

De plus, l'invention est compatible avec les techniques usuelles de fabrication des circuits électroniques, qu'il s'agisse d'une réalisation en utilisant les technologies de fabrication des circuits imprimés ou de fabrication en couches minces des circuits intégrés. A titre d'exemple particulier de réalisation, les épaisseurs respectives des enroulements plans sont comprises entre 0,1 et 10 µm.

En outre, la forme des vias pourra être quelconque (carrée, ronde, etc.), choisie par exemple selon la forme des vias disponibles dans la technologie utilisée.

Enfin, l'invention est compatible avec l'intégration d'un noyau magnétique axial au centre de la structure.

## Revendications

1. Elément inductif (3, 3', 3") formé d'enroulements plans (31, 32, 33, 34, 35, 36) dans différents niveaux conducteurs (M1, M2, M3, M4), **caractérisé en ce que** les enroulements sont réalisés dans un nombre (N) de niveaux inférieurs d'une unité par rapport au nombre (N+1) d'enroulements, les enroulements étant reliés les uns aux autres au moyen d'un nombre (N) de vias (51, 52, 53, 54, 55) égal au nombre de niveaux conducteurs et deux (32, 33) des enroulements étant interdigités dans un même niveau (M2).

2. Elément inductif selon la revendication 1, dans lequel les bornes (311, 321) d'accès à l'élément inductif sont à l'extérieur de deux enroulements (31, 32) formés dans deux niveaux différents (M1, M2).

3. Elément inductif selon la revendication 1 ou 2, dans lequel les enroulements (31, 32, 33, 34, 35, 36) sont de forme générale rectangulaire, circulaire ou octogonale..

4. Elément inductif selon l'une quelconque des revendications 1 à 3, dans lequel les enroulements (31, 32, 33, 34, 35, 36) ont la même largeur de piste et un même espacement entre les tours.

5. Elément inductif selon l'une quelconque des revendications 1 à 3, dans lequel les enroulements (31, 32, 33, 34, 35, 36) ont des largeurs de piste et/ou des espacements entre les tours différents d'un niveau à l'autre.

6. Elément inductif selon l'une quelconque des revendications 1 à 5, dans lequel les enroulements (31, 32, 33, 34, 35, 36) sont formés dans des niveaux de métallisation (M1, M2, M3, M4) d'une technologie d'intégration de circuits passifs.

7. Elément inductif selon l'une quelconque des revendications 1 à 5, dans lequel les enroulements (31, 32, 33, 34, 35, 36) sont formés dans des niveaux de métallisation (M1, M2, M3, M4) d'un circuit intégré.

8. Filtre passif comportant au moins un élément inductif selon l'une quelconque des revendications 1 à 7.

9. Circuit de protection contre des décharges électrostatiques comportant au moins un élément inductif selon l'une quelconque des revendications 1 à 7.

10. Circuit d'alimentation comportant au moins un élément inductif selon l'une quelconque des revendications 1 à 7.

11. Dispositif d'émission-réception radiofréquence comportant au moins un élément inductif selon l'une quelconque des revendications 1 à 7.

## Claims

1. An inductive element (3, 3', 3") formed of planar windings (31, 32, 33, 34, 35, 36) in different conductive levels (M1, M2, M3, M4), wherein the windings are formed in a number (N) of levels smaller by one unit than the number (N+1) of windings, the windings being connected to one another by means of a number (N) of vias (51, 52, 53, 54, 55) equal to the number of conductive levels and two (32, 33) of the windings being interdigited in a same level (M2).

2. The inductive element of claim 1, wherein the terminals (311, 321) of access to the inductive element are outside of two windings (31, 32) formed in two different levels (M1, M2).

3. The inductive element of claim 1 or 2, wherein the windings (31, 32, 33, 34, 35, 36) have a general rectangular, circular, or octagonal shape.

4. The inductive element of any of claims 1 to 3, wherein the windings (31, 32, 33, 34, 35, 36) have the same track width and a same spacing between turns.

5. The inductive element of any of claims 1 to 3, wherein the windings (31, 32, 33, 34, 35, 36) have track widths and/or spacings between the turns which are different from one level to the other.

6. The inductive element of any of claims 1 to 5, wherein the windings (31, 32, 33, 34, 35, 36) are formed in metallization levels (M1, M2, M3, M4) of a passive circuit integration technology.

7. The inductive element of any of claims 1 to 5, wherein the windings (31, 32, 33, 34, 35, 36) are formed in metallization levels (M1, M2, M3, M4) of an integrated circuit.

8. A passive filter comprising at least one inductive element of any of claims 1 to 7.

9. A circuit of protection against electrostatic discharges comprising at least one inductive element of any of claims 1 to 7.

10. A supply circuit comprising at least one inductive element of any of claims 1 to 7.

11. A radio-frequency transceiver device comprising at least one inductive element of any of claims 1 to 7.

## Patentansprüche

1. Ein induktives Element (3, 3', 3"), gebildet aus planaren Wicklungen (31, 32, 33, 34, 35, 36) in verschiedenen leitenden Ebenen (M1, M2, M3, M4), wobei die Wicklungen in einer Anzahl (N) von Ebenen gebildet werden, die um eine Einheit kleiner ist als die Anzahl (N+1) von Wicklungen, wobei die Wicklungen miteinander verbunden sind mittels einer Anzahl (N) von Vias bzw. Durchkontaktierungen (51, 52, 53, 54, 55), die gleich der Anzahl von leitenden Ebenen ist, und zwei (32, 33) der Wicklungen in einer gleichen Ebene (M2) ineinandergreifen.

2. Induktives Element nach Anspruch 1, wobei die Zugangsanschlüsse bzw. -terminals (311, 321) zu dem induktiven Element außerhalb der zwei Wicklungen (31, 32) sind, die in zwei unterschiedlichen Ebenen (M1, M2) gebildet sind.

3. Induktives Element nach Anspruch 1 oder 2, wobei die Wicklungen (31, 32, 33, 34, 35, 36) eine im Allgemeinen rechteckige, zirkulare oder oktagonale Form besitzen.

4. Induktives Element nach irgendeinem der Ansprüche 1 bis 3, wobei die Wicklungen (31, 32, 33, 34, 35, 36) die gleiche Spurbreite und einen gleichen Abstand zwischen Windungen besitzen.

5. Induktives Element nach irgendeinem der Ansprüche 1 bis 3, wobei die Wicklungen (31, 32, 33, 34, 35, 36) Spurbreiten und/oder Abstände zwischen den Windungen besitzen, die von einer Ebene zu der nächsten verschieden sind.

6. Induktives Element nach irgendeinem der Ansprüche 1 bis 5, wobei die Wicklungen (31, 32, 33, 34, 35, 36) in Metallisierungsebenen (M1, M2, M3, M4) von einer passiven Schaltungsintegrationstechnologie gebildet werden.

7. Induktives Element nach irgendeinem der Ansprüche 1 bis 5, wobei die Wicklungen (31, 32, 33, 34, 35, 36) in Metallisierungsebenen (M1, M2, M3, M4) einer integrierten Schaltung gebildet werden.

8. Ein passives Filter, das wenigstens ein induktives Element nach irgendeinem der Ansprüche 1 bis 7 aufweist.

9. Eine Schutzschaltung gegen elektrostatische Entladungen, die wenigstens ein induktives Element nach irgendeinem der Ansprüche 1 bis 7 aufweist.

10. Eine Versorgungsschaltung, die wenigstens ein induktives Element nach irgendeinem der Ansprüche 1 bis 7 aufweist.

11. Eine Hochfrequenz-Transceiver-Vorrichtung, die wenigstens ein induktives Element nach irgendeinem der Ansprüche 1 bis 7 aufweist.
